Europäisches Patentamt

European Patent Office

Office européen des brevets

(19)

(11) Numéro de publication: **0 402 282**

**A2**

(12) **DEMANDE DE BREVET EUROPEEN**

(21) Numéro de dépôt: 90420265.2

(22) Date de dépôt: 01.06.90

(51) Int. Cl.5: **H05H 1/46, H01J 37/32**

(30) Priorité: 05.06.89 FR 8907627

(43) Date de publication de la demande:
**12.12.90 Bulletin 90/50**

(84) Etats contractants désignés:
**CH DE GB IT LI NL**

(71) Demandeur: **CENTRE NATIONAL DE LA RECHERCHE SCIENTIFIQUE (CNRS)**
**15, Quai Anatole France**
**F-75700 Paris Cedex 07(FR)**

Demandeur: **ETAT FRANCAIS représenté par le Ministre des Postes, Télécommunications et de l'Espace**
**(CENTRE NATIONAL D'ETUDES DES TELECOMMUNICATIONS) C.N.E.T. 38-40 rue**

du Général Leclerc
F-92131 Issy-les-Moulineaux(FR)

(72) Inventeur: **Pelletier, Jacques Henri**
**Chemin du Fort, Le Mûrier**
**F-38400 St Martin D'Heres(FR)**
Inventeur: **Arnal, Yves Alban, Marie**
**5 Allée de la Treille**
**F-38320 Poisat(FR)**
Inventeur: **Pichot, Michel**
**11 Chemin du Couvent**
**F-38200 Grenoble(FR)**

(74) Mandataire: **Ropital-Bonvarlet, Claude**
**Cabinet BEAU DE LOMENIE, 51, avenue Jean-Jaurès**
**F-69007 Lyon(FR)**

(54) **Dispositif de couplage et de distribution d'une énergie micro-onde sur un excitateur pour la production d'un plasma.**

(57) - Production d'un plasma.

- Le dispositif de couplage et de distribution d'une énergie micro-onde sur au moins un excitateur est caractérisé en ce qu'il comporte :

. une première enceinte (1) dans laquelle règne l'énergie micro-onde,

. une seconde enceinte (4) contenant un milieu gazeux à ioniser,

. une première série d'au moins un passage (7) de communication entre les deux enceintes (1, 4),

. et, pour chaque passage de communication (7), un excitateur (13) monté pour traverser le passage à distance de la surface interne de ce dernier et pour s'étendre, d'une part, au moins à l'intérieur de la première enceinte (1) pour coupler une partie de l'énergie micro-onde et, d'autre part, au moins à l'intérieur de la seconde enceinte (4) pour conduire localement l'énergie micro-onde couplée en relation du milieu gazeux.

- Application à l'exécution d'un plasma par micro-ondes.

Fig-1

## DISPOSITIF DE COUPLAGE ET DE DISTRIBUTION D'UNE ENERGIE MICRO-ONDE SUR UN EXCITATEUR POUR LA PRODUCTION D'UN PLASMA

La présente invention concerne le domaine technique général de la production de plasma à partir de milieu gazeux de toute nature, en vue d'applications très diverses, telles que les traitements de surface ou la production de faisceaux d'ions.

L'invention vise, plus précisément, le domaine de l'excitation d'un plasma par micro-ondes, en particulier à la résonance cyclotronique électronique.

La demande de brevet français n° **85 08 836** décrit une technique d'excitation de plasma à la résonance cyclotronique électronique. Cette résonance est obtenue pour un champ magnétique **B** et une fréquence d'excitation **f**, liés par la relation :

$$B = \frac{2\pi m f}{e}$$

où **m** et **e** sont la masse et la charge de l'électron. A titre d'exemple, pour une fréquence de 2,45 GHz, un champ magnétique de 0,0875 Tesla est nécessaire pour obtenir la résonance.

La technique décrite dans la demande de brevet français ci-dessus nécessite la mise en oeuvre d'aimants permanents créant chacun une surface à champ magnétique constant et d'intensité correspondant à la résonance cyclotronique électronique. L'énergie électromagnétique est amenée au niveau de la zone de résonance par des excitateurs de plasma constitués chacun par un élément filaire métallique. Chaque excitateur est disposé à l'intérieur d'un réacteur plasma et en relation avec des aimants permanents qui se trouvent montés sur la paroi du réacteur.

Etant donné que les plasmas excités par cette technique travaillent à pression réduite, de l'ordre du décipascal (0,1 Pascal), l'énergie micro-onde est introduite dans le réacteur à travers un passage étanche comportant un élément de liaison isolé électriquement par rapport au passage, de manière à constituer une structure de type coaxial. L'élément de liaison est raccordé, vers l'intérieur de l'enceinte, à un excitateur et, vers l'extérieur de l'enceinte, par exemple à l'âme d'un câble coaxial d'amenée de l'énergie électromagnétique.

L'utilisation d'une telle enceinte, équipée d'un ensemble d'excitateurs, impose que ces excitateurs soient alimentés chacun à partir de sources indépendantes de micro-ondes ou à partir d'une source unique. Dans le premier cas, chaque excitateur est associé à au moins une source micro-onde, un moyen d'adaptation d'impédance et à des moyens de mesure éventuels. Dans le cas d'une source unique, il convient de mettre en oeuvre au moins un répartiteur d'énergie micro-onde auquel sont associés des moyens d'adaptation d'impédance et de mesures. Il apparaît que la mise en oeuvre d'une telle technique ne donne pas entière satisfaction en pratique.

En effet, un premier inconvénient concerne les répartiteurs d'énergie micro-onde qui sont généralement constitués par des prises coaxiales dont l'âme centrale pénètre plus ou moins, soit dans un guide, soit dans une cavité micro-onde. Sauf cas particulier, la position des prises coaxiales est complexe et doit être calculée sur ordinateur. De plus, l'équilibrage entre les différentes prises coaxiales est délicat et nécessite de nombreux réglages successifs jouant sur la profondeur de leur pénétration.

Des inconvénients supplémentaires de cette technique sont liés à la mise en oeuvre de passages étanches de type coaxial, assurant l'introduction de l'énergie micro-onde dans la zone d'excitation du plasma.

Ainsi, les connexions de l'âme du câble coaxial et de l'excitateur, à l'élément de liaison du passage étanche, sont sources de ruptures d'impédance et d'échauffements, ce qui entraînent des pertes énergétiques.

De plus, le diélectrique des passages étanches, en regard du plasma, subit à la fois l'échauffement dû au plasma et les contaminations dues aux traitements plasma. Ces contaminations sont d'autant plus importantes que la puissance micro-onde disponible pour l'excitation du plasma est élevée sur le passage étanche. Toutefois, étant donné que l'énergie micro-onde est absorbée par l'excitation plasma et diminue en s'éloignant du passage étanche, il apparaît que la transmission d'une puissance élevée nécessite de réaliser les passages étanches de type coaxial, selon une technologie délicate et coûteuse.

Par ailleurs, l'application de fortes puissances micro-ondes nécessite un refroidissement efficace de chaque excitateur. L'utilisation de passages étanches rend très difficile le refroidissement complet des excitateurs qui s'effectue généralement par circulation d'un fluide de refroidissement injecté à partir de l'extrémité libre des excitateurs. En réalité, le passage étanche et le câble coaxial ne peuvent être refroidis que par conduction depuis l'excitateur. Il en résulte que la puissance micro-onde admissible est limitée par l'efficacité du refroidissement de chacun des excitateurs et par la tenue en puissance du diélectrique constitutif des passages étanches du type coaxial.

Un autre inconvénient de cette technique d'excitation du plasma est relative à la puissance micro-onde qui décroît à partir de la source micro-onde, au fur et à mesure le long de l'excitateur. La propagation des micro-ondes ne peut s'effectuer qu'avec des pertes et la densité de plasma obtenu décroît en même temps que la puissance micro-onde.

La présente invention vise donc à remédier aux inconvénients énoncés ci-dessus, en proposant un dispositif de couplage de l'énergie micro-onde sur au moins un excitateur, de manière à obtenir un meilleur couplage de l'énergie micro-onde.

L'invention a pour objet de proposer un dispositif de répartition de l'énergie micro-onde sur un ensemble d'excitateur permettant de s'affranchir de l'utilisation de passages étanches du type coaxial.

L'invention a pour objet également d'offrir un dispositif de répartition assurant la distribution de l'énergie micro-onde sur toute la longueur de l'excitateur.

Pour atteindre les buts énoncés ci-dessus, le dispositif selon l'invention, de couplage et de distribution d'une énergie micro-onde sur au moins un excitateur, pour la production d'un plasma, est caractérisé en ce qu'il comporte :
- une première enceinte dans laquelle règne l'énergie micro-onde,
- une seconde enceinte contenant un milieu gazeux à ioniser,
- une première série d'au moins un passage de communication entre les deux enceintes,
- et, pour chaque passage de communication, un excitateur monté pour traverser le passage à distance de la surface interne de ce dernier et pour s'étendre, d'une part, au moins à l'intérieur de la première enceinte pour coupler une partie de l'énergie micro-onde et, d'autre part, au moins à l'intérieur de la seconde enceinte pour conduire localement l'énergie micro-onde couplée en relation du milieu gazeux, de telle sorte que l'excitateur constitue, avec le passage et les parties des parois des enceintes placées en regard de l'excitateur, une structure de type coaxial.

Diverses autres caractéristiques ressortent de la description faite ci-dessous en référence aux dessins annexés qui montrent, à titre d'exemples non limitatifs, des formes de réalisation de l'objet de l'invention.

La **fig. 1** illustre de façon schématique, en coupe radiale, une variante de réalisation d'un dispositif de couplage selon l'invention.

La **fig. 2a** est une vue en perspective, en écorché, d'une variante de réalisation d'un dispositif selon l'invention.

La **fig. 2b** est une vue en perspective partielle d'une autre variante de réalisation d'un dispositif conforme à l'invention.

La **fig. 3** est une coupe prise sensiblement selon la ligne III-III de la **fig. 1**.

La **fig. 4** illustre de façon schématique, en coupe radiale, une autre variante de réalisation d'un dispositif conforme à l'invention.

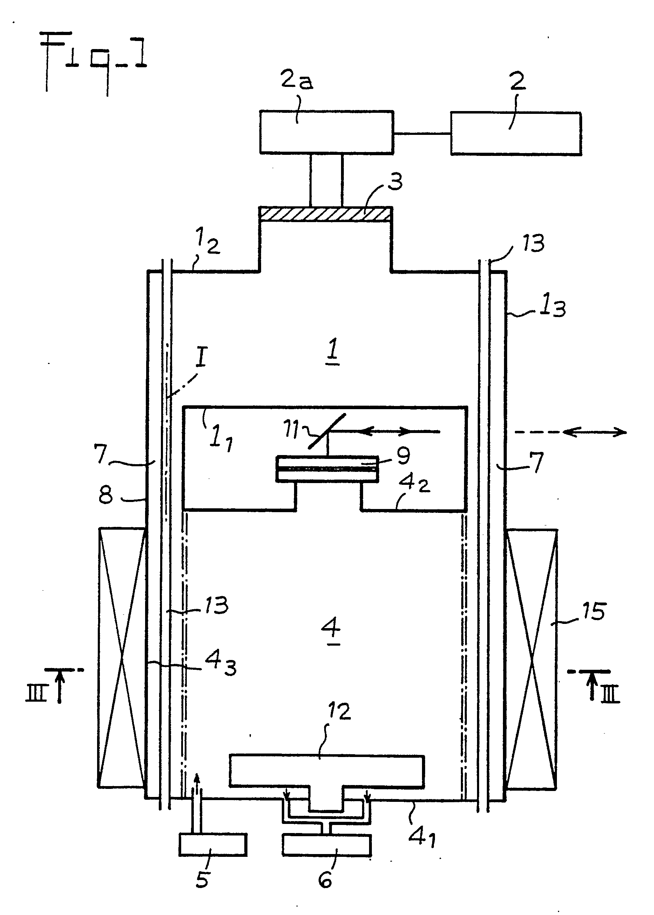

La **fig. 1** illustre un exemple de réalisation d'un dispositif selon l'invention, de couplage et de distribution d'une énergie micro-onde pour la production d'un plasma, en vue d'applications très diverses, telles que les traitements de surface ou la production de faisceaux d'ions.

Le dispositif selon l'invention comporte une première enceinte **1** métallique, dans laquelle règne une énergie micro-onde produite dans l'enceinte par tous moyens connus appropriés, ou introduite dans l'enceinte, comme illustré sur le dessin. Dans ce dernier cas, la puissance micro-onde, qui est fournie par un générateur **2** associé à un adaptateur d'impédance **2a**, est introduite dans l'enceinte **1** à travers un système étanche **3**, tel qu'une fenêtre diélectrique.

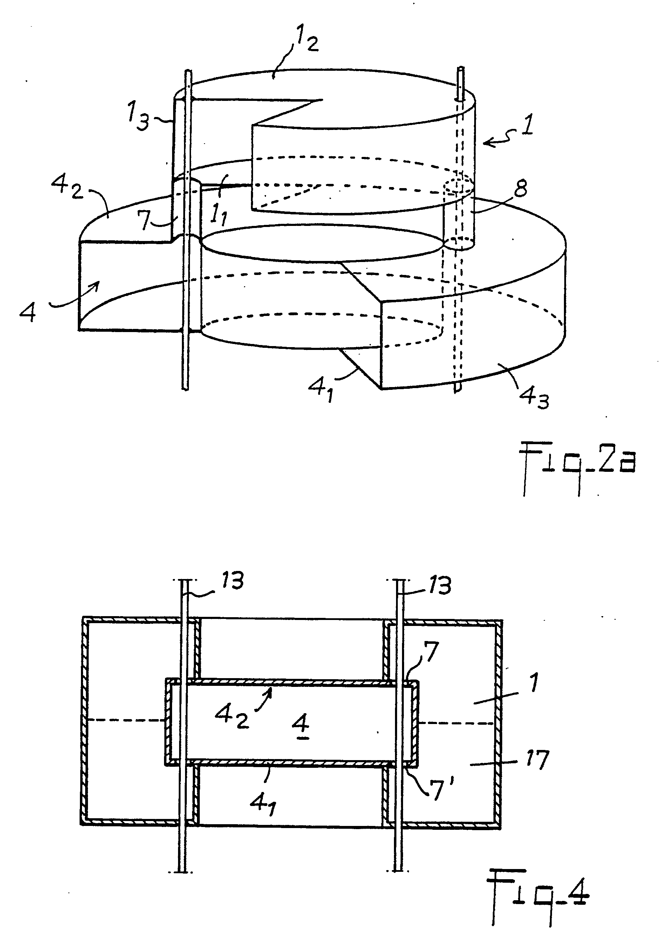

L'enceinte **1** comporte une paroi de fond **1₁** et une paroi de dessus **1₂** raccordées entre elles par une paroi latérale **1₃**, de manière à former, de préférence mais non exclusivement, une enceinte cylindrique de section droite transversale circulaire, comme cela apparaît à la **fig. 2A**.

Le dispositif selon l'invention comporte également une seconde enceinte **4** métallique contenant un milieu gazeux à ioniser introduit par un moyen convenable connu **5**. L'enceinte **4** est également équipée d'un moyen de pompage **6** permettant de maintenir la pression du gaz à ioniser à la valeur désirée, qui peut être, par exemple, de l'ordre de quelques $10^{-3}$ à quelques Pascals suivant la nature du gaz. L'enceinte **4** est constituée par des parois de fond **4₁** et de dessus **4₂** raccordées entre elles par une paroi latérale **4₃**, de manière à former, de préférence mais non exclusivement, une enceinte de section droite transversale circulaire. L'enceinte **4**, dont la fonction apparaîtra plus clairement dans la suite de la description, peut présenter des formes générales diverses, telles que cylindriques (**fig. 1**), toriques (**fig. 2A**) ou comportant au moins une face plane (**fig. 2B**). De la même façon, il doit être considéré que l'enceinte **1** peut présenter des formes diverses telles que décrites ci-dessus en combinaison avec l'une quelconque des formes données à l'enceinte **4**.

Dans le cas où l'enceinte **1** présente une forme torique ou comporte au moins une face plane, il peut être envisagé d'utiliser, avantageusement, un résonnateur en anneau de type classique, parcouru par une onde progressive.

Selon l'invention, les enceintes **1**, **4** sont reliées entre elles par une première série d'au moins un passage de communication **7** comportant chacun un axe normal I s'étendant au moins à proximité des parois latérales des enceintes 1, 4. Dans l'exemple illustré, chaque passage de communication 7 est formé par un conduit tubulaire 8 de section droite transversale, de préférence circulaire mais non exclusivement. Les conduits tubulaires, dont la fonction apparaîtra plus clairement dans la suite de la description, peuvent présenter une longueur se réduisant à l'épaisseur des parois de fond $1_1$ et de dessus $4_2$, de sorte que les enceintes se trouvent accolées (**fig. 2B**). De préférence, les conduits tubulaires 8 possèdent une longueur déterminée pour obtenir un éloignement relatif entre les enceintes, de manière à permettre la mise en place d'un hublot 9 sur la paroi de dessus $4_2$ de l'enceinte 4. Le hublot 9 permet, à l'aide d'un moyen de visée optique 11, l'observation du volume interne de l'enceinte 4 dans laquelle se déroule, par exemple, un traitement de surface d'un échantillon porté par un porte-substrat 12. Il doit être considéré que le moyen de visée optique 11 peut également traverser l'enceinte 1 dans sa partie centrale, si cette enceinte présente une forme torique.

Les enceintes 1 et 4, qui constituent ainsi une structure parfaitement étanche, peuvent être réalisées sous une forme, soit monobloc ou soit séparée permettant un démontage aisé des enceintes. Bien entendu, ces enceintes sont métalliques et peuvent être recouvertes d'un diélectrique ou d'une métallisation.

Le dispositif selon l'invention comporte également, pour chaque conduit tubulaire de communication 8, un excitateur 13 de plasma constitué par un élément filaire métallique pouvant être recouvert d'un diélectrique ou d'une métallisation. Chaque excitateur 13 est monté pour traverser un conduit tubulaire 8, à distance de la surface interne du conduit 8, de manière à constituer, avec le conduit, une structure de type coaxial. L'excitateur 13, qui s'étend selon une direction générale sensiblement parallèlement à l'axe normal I, peut être décalé par rapport à cet axe, sans toutefois être en contact avec le conduit.

Chaque excitateur 13 s'étend à l'intérieur de la première enceinte 1, à proximité de la paroi latérale $1_3$, de manière à assurer un couplage sur l'excitateur, d'une partie de l'énergie micro-onde régnant dans l'enceinte 1 qui assure ainsi une fonction de répartition de l'énergie sur l'ensemble des excitateurs. Par ailleurs, chaque excitateur 13 s'étend aussi à l'intérieur de la seconde enceinte 4, à proximité de la paroi latérale $4_3$, de manière que l'excitateur assure la propagation de l'énergie micro-onde tout le long de l'excitateur.

Bien entendu, il peut être envisagé de mettre en oeuvre un ou plusieurs excitateurs 13 dont le nombre est adapté à la densité de plasma maximale à atteindre. Si plusieurs excitateurs sont utilisés, ces derniers sont répartis régulièrement ou non à la périphérie et le long des parois des enceintes.

Par ailleurs, il doit être considéré que l'enceinte de répartition 1 de l'énergie micro-onde doit présenter des dimensions suffisamment importantes pour éviter toute coupure dans la propagation des micro-ondes et permettre un large couplage des micro-ondes sur la structure du type coaxial développé, formée, de part et d'autre du conduit tubulaire 8, par l'excitateur et la partie des parois $1_3$ et $4_3$ des enceintes, placée en regard de l'excitateur.

L'énergie micro-onde couplée dans l'enceinte de répartition 1 sur les structures coaxiales développées des excitateurs 13 se propage ensuite dans les conduits tubulaires 8, puis dans l'enceinte 4, sur les structures coaxiales développées des excitateurs 13. Bien entendu, les dimensions du conduit tubulaire 8 et de l'excitateur 13 sont choisies de manière à éviter l'excitation du plasma à l'intérieur du conduit tubulaire pour les conditions d'utilisation retenues.

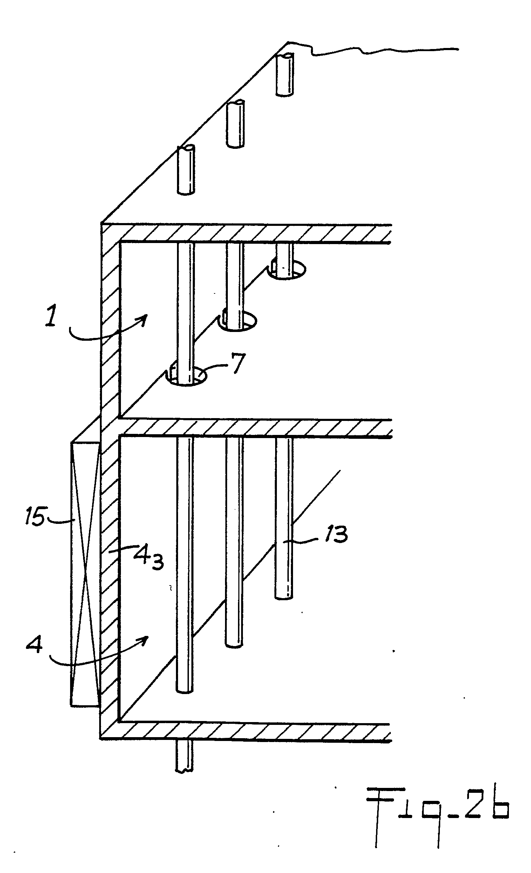

Tel que cela ressort plus précisément de la **fig. 3** et conformément à la demande de brevet français 85 08 836, chaque excitateur 13 est, de préférence, positionné à proximité d'une surface 14 à champ magnétique constant et dont l'intensité correspond à la résonance cyclotronique électronique. Cette surface à champ magnétique constant est créée par un aimant 15 monté, par exemple, sur la surface externe de la paroi $4_3$ en s'étendant en relation de l'excitateur 13 correspondant. Dans cette hypothèse, chaque excitateur 13 assume, supplémentairement à la fonction de propagation de l'énergie micro-onde, une fonction d'excitation du plasma.

Avantageusement, chaque excitateur 13 traverse au moins une et, de préférence, les deux enceintes 1 et 4 de part en part. Ainsi, tel que cela ressort plus précisément de la **fig. 1**, chaque excitateur traverse la paroi étanche de dessus $1_2$ de l'enceinte 1 et la paroi étanche de fond $4_1$ de l'enceinte 4. De ce fait, il est possible de faire circuler, à l'intérieur de chaque excitateur 13 qui présente une forme tubulaire, un fluide de refroidissement circulant selon un sens direct.

Dans le cas où les excitateurs ne traversent qu'une paroi étanche, chaque excitateur 13 peut être conformé, soit pour présenter un double tube assurant une double circulation ou soit pour être constitué selon un caloduc refroidi à l'une de ses extrémités.

Si les excitateurs ne traversent aucunes des parois étanches, il peut être prévu de réaliser le refroidissement à travers un diélectrique.

Le dispositif selon l'invention permet d'utiliser des excitateurs totalement indépendants entre eux sur lesquels la puissance micro-onde est bien répartie, ce qui améliore le couplage et donc le rendement des micro-ondes. De plus, la mise en oeuvre de tels excitateurs qui sont, de préférence, rectilignes ne nécessite aucun montage mécanique délicat.

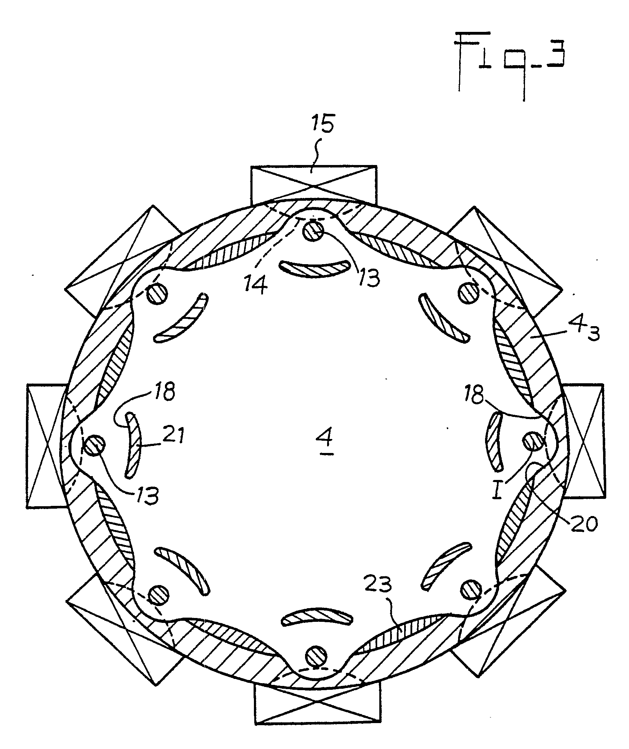

La **fig. 4** illustre une autre variante de réalisation du dispositif selon l'invention, dans laquelle les excitateurs **13** peuvent coupler une énergie micro-onde à chacune de leur extrémité.

A cet effet, la seconde enceinte **4** comporte une seconde série d'au moins un passage de communication **7**′ de forme, de fonction et en nombre identiques aux passages **7** de la première série. Ces passages **7**′, qui sont ménagés dans l'exemple illustré dans la paroi de fond **4₁**, autorisent une communication, de manière étanche, avec une enceinte **17** dans laquelle règne une énergie micro-onde.

Cette enceinte **17** peut être formée avantageusement par la première enceinte **1** qui présente alors une forme particulière pour s'étendre de part et d'autre des parois de dessus et de fond de l'enceinte **4**. La forme particulière de cette enceinte est, de préférence, torique, de manière à permettre une observation à l'intérieur de l'enceinte **4**.

Bien entendu, comme cela est représenté en traits discontinus sur la **fig. 4**, il peut être envisagé que l'enceinte **17** constitue une enceinte indépendante de l'enceinte **1** et présente une forme générale diverse telle que décrite précédemment.

Il est à noter que les excitateurs **13** traversent ou non la ou les parois étanches des enceintes **1** et/ou **17** en fonction du mode de refroidissement choisi.

Tel que cela ressort plus précisément de la **fig. 3**, le dispositif selon l'invention comporte un perfectionnement assurant une distribution et un confinement des micro-ondes le long de la partie de l'excitateur placée dans l'enceinte de production d'un plasma.

A cet effet, chaque excitateur **13** est positionné sur au moins une partie de sa longueur placée dans la seconde enceinte **4**, en relation de distance avec au moins une surface métallique **18** comportant un profil droit transversal au moins concave tourné vers l'excitateur. Cette surface **18** est constituée par le fond d'une rainure **20** ménagée dans la paroi **4₃** de l'enceinte **4** et comportant un profil droit transversal concave tourné vers l'excitateur. Cette rainure **20** présente donc un profil de toute forme concave, telle que circulaire. De ce fait, l'énergie micro-onde peut se propager dans des zones non soumises à la résonance, de manière à obtenir une propagation de l'énergie micro-onde avec un minimum de pertes. De plus, l'excitateur **13** se trouve ainsi au plus près de l'aimant sans toutefois affaiblir notablement la paroi de l'enceinte, ce qui permet l'utilisation d'aimants moins puissants pour la même valeur de résonance à atteindre.

La surface métallique **18** peut être constituée également par la face avant d'un réflecteur **21** monté à l'opposé de la paroi **4₃** de l'enceinte par rapport à l'excitateur **13**. Ce réflecteur permet de confiner l'énergie micro-onde dans la zone de propagation et d'occulter les trajectoires électroniques qui s'éloignent trop de la paroi de l'enceinte. Pour assumer une telle fonction, il peut être prévu que le réflecteur **21** comporte aussi un profil droit transversal différent et divers, tel que rectiligne ou convexe tourné vers l'excitateur.

Bien entendu, il peut être envisagé de prévoir de positionner un excitateur **13** en relation d'une rainure **20** et/ou d'un réflecteur **21**.

Les rainures **20** et/ou les réflecteurs **21** sont, de préférence, aménagés pour assurer la circulation d'un fluide de refroidissement. Dans le cas où les excitateurs **13** ne traversent aucune des parois étanches des enceintes, il peut être prévu de réaliser le refroidissement à travers un diélectrique et, en particulier, à partir de la surface **18** du réflecteur **21**.

Le dispositif selon l'invention comporte également un élément amagnétique **23** monté sur la face interne de la paroi **4₃** de l'enceinte **4** entre deux rainures **20** successives. Cet élément **23** comporte un profil convexe tourné vers l'intérieur de l'enceinte. Le profil de cet élément est déterminé de manière à éviter la formation de festons secondaires de champs magnétiques susceptibles de créer des espèces ioniques à proximité de la paroi.

L'invention n'est pas limitée aux exemples décrits et représentés, car diverses modifications peuvent y être apportées sans sortir de son cadre.

**Revendications**

1 - Dispositif de couplage et de distribution d'une énergie micro-onde sur au moins un excitateur, pour la production d'un plasma, caractérisé en ce qu'il comporte :
. une première enceinte (**1**) dans laquelle règne l'énergie micro-onde,
. une seconde enceinte (**4**) contenant un milieu gazeux à ioniser,
. une première série d'au moins un passage (**7**) de communication entre les deux enceintes (**1, 4**),
. et, pour chaque passage de communication (**7**), un excitateur (**13**) monté pour traverser le passage à distance de la surface interne de ce dernier et pour s'étendre, d'une part, au moins à l'intérieur de la première enceinte (**1**) pour coupler une partie de l'énergie micro-onde et, d'autre part, au moins à l'intérieur de la seconde enceinte (**4**) pour conduire localement l'énergie micro-onde couplée en relation du milieu gazeux, de telle sorte que l'excitateur constitue, avec le passage (**7**) et les parties des parois des enceintes placées en regard de l'excitateur, une structure de type coaxial.

2 - Dispositif selon la revendication 1, caractérisé en ce que chaque excitateur (**13**) est positionné à proximité d'une surface (**14**) à champ magnétique constant créé par un aimant permanent (**15**) et dont l'intensité correspond à la résonance cyclotronique électronique.

3 - Dispositif selon la revendication 1, caractérisé en ce que la seconde enceinte (**4**) comporte une seconde série d'au moins un passage (**7'**) de communication avec une enceinte (**17**) dans laquelle règne une énergie micro-onde, de manière que chaque excitateur (**13**) traverse de part en part la seconde enceinte à travers un passage de communication (**7, 7'**) de chaque série.

4 - Dispositif selon l'une des revendications 1 à 3, caractérisé en ce qu'il comprend une série d'excitateurs (**13**) répartis à la périphérie et le long des parois des enceintes (**1, 4**).

5 - Dispositif selon la revendication 3, caractérisé en ce que l'enceinte (**17**) est formée par la première enceinte (**1**).

6 - Dispositif selon la revendication 3, caractérisé en ce que l'enceinte (**17**) forme une enceinte indépendante de la première enceinte (**1**).

7 - Dispositif selon la revendication 3, 5 ou 6, caractérisé en ce que chaque excitateur (**13**) traverse de part en part au moins l'une des enceintes (**4, 17**) dans lesquelles règne une énergie micro-onde, de manière à assurer, à partir de l'extérieur de l'enceinte, la circulation d'un fluide de refroidissement le long de l'excitateur.

8 - Dispositif selon l'une des revendications 1 à 7, caractérisé en ce qu'au moins l'une des enceintes (**1, 4 ou 17**) est constituée sous la forme d'un tore.

9 - Dispositif selon l'une des revendications 1 à 7, caractérisé en ce qu'au moins l'une des enceintes (**1, 4 ou 17**) comporte chacune au moins une face plane.

10 - Dispositif selon la revendication 1 et 3, caractérisé en ce que chaque passage (**7, 7'**) de communication d'au moins une série est constitué par un conduit tubulaire (**8**).

11 - Dispositif selon l'une des revendications 1 à 10, caractérisé en ce que chaque excitateur (**13**) est positionné sur au moins une partie de sa longueur placée dans la seconde enceinte, en relation de distance avec au moins une surface métallique (**18**) comportant un profil droit transversal au moins concave tourné vers l'excitateur.

12 - Dispositif selon la revendication 11, caractérisé en ce que la surface métallique (**18**) est constituée par le fond d'une rainure (**20**) ménagée dans la paroi de la seconde enceinte et comportant un profil droit transversal concave.

13 - Dispositif selon la revendication 11, caractérisé en ce que la surface métallique (**18**) est constituée par la face avant d'un réflecteur (**21**) positionné à l'opposé de la paroi de l'enceinte par rapport à l'excitateur, de manière à assurer le confinement de l'énergie micro-onde.

14 - Dispositif selon la revendication 11, caractérisé en ce que chaque excitateur est positionné en relation de distance avec une rainure (**20**) ménagée dans la paroi de la seconde enceinte et avec un réflecteur (**21**) positionné à l'opposé de la paroi de l'enceinte par rapport à l'excitateur.

15 - Dispositif selon la revendication 12 ou 14, caractérisé en ce qu'il comprend, entre deux rainures (**20**) successives, un élément amagnétique (**23**) porté par la paroi de l'enceinte et comportant un profil convexe tourné vers l'intérieur de l'enceinte.

*Fig-1*

Fig.2a

Fig.4

Fig.26

Fig.3